# EUROPÄISCHE PATENTSCHRIFT

(11) **EP 0 506 777 B1**
(45) Veröffentlichungstag und Bekanntmachung des Hinweises auf die Patenterteilung: **05.04.1995**
(21) Anmeldenummer: 91901527.1
(22) Anmeldetag: 14.12.1990
(51) Int. Cl.: H03H 9/64

(54) **OBERFLÄCHENWELLEN-REFLEKTORFILTER**
SURFACE WAVE REFLECTOR FILTER
FILTRE REFLECTEUR D'ONDES DE SURFACE

(30) Priorität: 20.12.1989 DE 3942148
(43) Veröffentlichungstag der Anmeldung: 07.10.1992
(73) Patentinhaber: SIEMENS AKTIENGESELLSCHAFT, 80333 München (DE)
(72) Erfinder: RUILE, Werner, D-8000 München 19 (DE); VISINTINI, Giuliano Dr., D-8025 Unterhaching (DE); MACHUI, Jürgen, D-8000 München 40 (DE)
(86) Internationale Anmeldenummer: EP9002192
(87) Internationale Veröffentlichungsnummer: WO9109464

(56) Entgegenhaltungen:
- GB-A- 1 473 661
- GB-A- 2 056 809
- Patent Abstracts of Japan, Band 8, Nr. 78 (E-237) (1515) 10 April 1984 & JP A 58223912

## Beschreibung

Die vorliegende Erfindung bezieht sich auf ein mit akustischen Oberflächenwellen arbeitendes Reflektorfilter mit mindestens einem Eingangswandler, mindestens einem Ausgangswandler und mindestens einer Reflektorstruktur. Die Reflektorstruktur (-en) ist (sind) als 180°-Reflektor wirksam und Eingangswandler, Ausgangswandler und Reflektorstruktur sind in-line auf dem Oberflächenwellensubstrat angeordnet.

Aus den Druckschriften US-A-4 484 160 und 4 520 330 ist ein als RAC-Filter bezeichnetes Reflektor-Oberflächenwellenfilter mit einem Eingangswandler, einem Ausgangswandler und zwei Reflektorstrukturen bekannt, die mit schräggestellten Reflektorfingern sich (nebeneinander liegend) derart gegenüberstehen, daß eine in den einen Reflektor hineinlaufende akustische Welle um etwa 90° umgelenkt in den anderen Reflektor gelangt und von letzterem wieder mit etwa 90° Richtungsänderung dem Ausgangswandler zugeführt wird. Ein solches Filter eignet sich für die Verwendung als Zeitfenster. Die Fingerstrukturen der erwähnten Reflektoren können der gewünschten Übertragungsfunktion entsprechend gewichtet und/oder dispersiv sein. Als Fingerwichtung kann insbesondere Fingerverschiebungswichtung, Fingerweglaßwichtung und Fingerdrehung vorgesehen sein. Für ein solches Reflektor-Oberflächenwellenfilter benötigt man ein Substrat mit verringerter Länge desselben, weil trotz erheblicher Länge der Reflektoren infolge des gefalteten akustischen Weges keine einer üblichen in-line-Anordnung entsprechende Substratlänge benötigt wird.

Ein Nachteil eines solchen Reflektorfilters ist, daß eine gewisse Temperaturabhängigkeit der Winkelgenauigkeit der 90°-Reflexion vorliegt, und zwar dies auch bei einem Substrat aus Quarz. Auch hat ein solches Filter ein gewisses Maß an Übertragungsverlusten.

Für ein solches Reflektor-Oberflächenwellenfilter ist es wichtig, daß die Übertragung des elektrischen Eingangssignals in das elektrische Ausgangssignals des Filters praktisch ausschließlich über den Weg der akustischen Welle, und zwar über den bzw. die Reflektoren erfolgt. Eine direkte Signalübertragung zwischen Eingangswandler und Ausgangswandler, also unter Umgehung der Reflektorstruktur (-en) muß praktisch ausgeschlossen sein, auch wenn diese direkte Übertragung zwischen Eingangswandler und Ausgangswandler auf akustischem Wege erfolgt. Dies ist bei Resonatorfiltern der Regelfall. In einem Resonatorfilter ist in erster Linie die Resonanzeigenschaft der gesamten Filteranordnung maßgebend für die wesentliche Charakteristik eines solchen Filters, nämlich für die Formung (Bandbreite, Gruppenlaufzeit und dergleichen) seines Durchlaßbereiches.

Von einem Resonatorfilter zu unterscheiden ist ein hier relevantes Reflektorfilter, dessen wesentliche Charakteristik des Durchlaßbereiches durch die Eigenschaft des Reflektors als solchem bestimmt wird. Bei einem Reflektorfilter sind Resonanzen der gesamten Filteranordnung zu vermeiden.

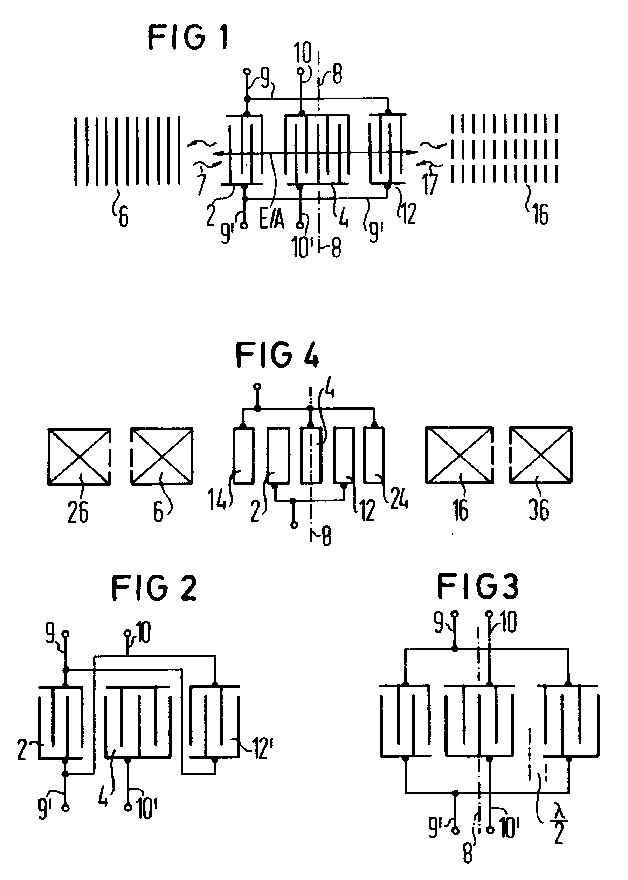

Ein einspuriges Reflektorfilter ist aus IEEE Trans. Ultrasonics Vol. 35 (1988), Seiten 61 ff, Figur 3d bekannt. Dieses Reflektorfilter hat einen Ausgangswandler und einen Eingangswandler mit zur Längsachse des Filters schräggestellten Wandlerfingern, wobei die Schrägstellung des einen Wandlers entgegengesetzt der des anderen ist. Die zu dieser Achse ortogonal gerichteten Elektroden der beiden Reflektoren reflektieren die im Filter verlaufenden akustischen Wellen in einem von 180° abweichenden Winkel. Mit diesem Reflektorfilter mit schräggestellten Wandlerfingern soll eine direkte akustische Signalübertragung vom Eingangswandler zum Ausgangswandler minimiert werden. Der zu dieser Minimierung führende Wellen-Auslöschungseffekt ist dort jedoch wellenlängenäbhängig, so daß dieses Ergebnis nur für einen schmalbandigen Wellenlängenbereich erreichbar ist. Die vorgesehene Schrägstellung der Wandlerfinger führt auch zu zusätzlichen Verlusten. Wegen der auftretenden schräggerichteten Wellenfronten ist ein solches Reflektorfilter schwierig zu berechnen.

Aufgabe der vorliegenden Erfindung ist es, ein mit akustischen Oberflächenwellen arbeitendes, leicht zu berechnendes Reflektorfilter anzugeben, das bei, bezogen auf die vorgegebenen Anforderungen bezüglich Selektivität als Reflektorfilter, möglichst geringer Größe des notwendigen Substratkörpers ein Optimum an Temperaturunabhängigkeit seiner Eigenschaften, eingeschlossen die Reflexion, aufweist und gegebenenfalls dabei auch ein Minimum an Verlust an Signalenergie (low loss) hat. Das Filter soll ein möglichst geringes Übersprechen haben.

Diese Aufgabe wird mit einem mit akustischen Oberflächenwellen arbeitenden Reflektorfilter gelöst, das die im Patentanspruch 1 bzw. die im Anspruch 2 angegebenen Merkmale hat. Weitere vorteilhafte Ausgestaltungen eines solchen Filters gehen aus den Unteransprüchen hervor.

Unter "Oberflächenwellen" sind im Sinne der Erfindung in bzw. nahe der Oberfläche eines Festkörpers (Substrat) verlaufende akustische Wellen zu verstehen, die genauer spezifiziert als Rayleighwellen, Bleusteinwellen, SSBW-Wellen (surface skimming bulk waves) und dgl. bezeichnet werden und deren jeweiliges Auftreten von der jeweiligen Orientierung der Kristallrichtung des Substrats und der Anordnung der Oberflächenwellen-Strukturen zueinander abhängig ist.

Ein wesentliches Merkmal eines erfindungsgemäßen Filters ist die einspurige in-line Anordnung von Eingangswandler-, Ausgangswandler-und Reflektorstruktur-Anordnungen, wobei der wenigstens eine vorhandene Reflektor die akustische Welle genau im Winkel von 180° in sich zurückreflektiert. Dies macht das Filter unter Anwendung von Standardmethoden leicht berechenbar und vermeidet Temperaturabhängigkeiten des Filters mit von 180° abweichender Reflexion. Wesentlicher weiterer Gedanke der zum erfindungsgemäßen Filter geführt hat ist, eine hier als "mutually blind transducers-(MBT-)" bezeichnete Mehrwandleranordnungen zu verwenden. Weitere Einzelheiten zu einer erfindungsgemäßen MBT-Anordnung gehen aus der nachfolgenden Beschreibung zu Ausführungsbeispielen hervor.

Im einfachsten Falle besteht ein erfindungsgemäßes Filter aus einer Eingangswandler-Anordnung, einer Ausgangswandler-Anordnung und einer Reflektorstruktur, wobei im einfachsten Falle die genannten Wandleranordnungen aus zwei Eingangswandlern und einem Ausgangswandler oder aus einem Eingangswandler und zwei Ausgangswandlern bestehen (und diese drei Wandler die MBT-Eigenschaft haben).

Die Fig. 1 zeigt ein einfaches Ausführungsbeispiel bzw. das Grundprinzip eines erfindungsgemäßen Filters und die Fig. 1 bis 4 zeigen weitere Ausgestaltungen mit jeweils mehrfachen Strukturen für Eingangswandler und Ausgangswandler und/oder Reflektorstrukturen.

Das Filter 1 gemäß Fig. 1 hat als angenommene Eingangswandler zwei Wandler 2 und 12 und als angenommenen Ausgangswandler den Wandler 4. Mit 6 ist einer in sich zurückreflektierende (genau 180°) Reflektorstruktur bezeichnet. Die Hauptwellenausbreitungsrichtung im Filter 1 ist mit der Achse E/A bezeichnet. Diese Achse ist auch die in-line Achse des Filters. Parallel zu dieser Achse ist mit 7 die hin- und herlaufende akustische Welle bezeichnet.

Die Wandler 2, 12 und 4 sind zusammengenommen hier als "Wandlersystem" definiert. Dieses Wandlersystem hat eine gemeinsame Mitte die mit der Achse 8 angegeben und bezeichnet ist. Diese Achse 8 "teilt" den Ausgangswandler 4 in zwei zueinander spiegelsymmetrische Hälften. Die mit den Signal-Eingangsanschlüssen 9, 9′verbundenen Eingangswandler 2 und 12 sind in Bezug auf den Ausgangswandler 4 antisymmetrisch wirksam. Die in Bezug auf die Achse 8 unsymmetrischen Fingerstrukturen der Wandler 2 und 12 bewirken bei der dargestellten Anschlußweise, daß von den Wandlern 2 und 12 ausgehende, dem Ausgangswandler 4 akustisch auf direktem Wege zugeführte Signale als phasenentgegengesetzt im Ausgangswandler 4 ausgelöscht werden. Von den Anschlüssen 9, 9′ gelangt also auf "direktem" oder unmittelbarem akustischen Wege kein Signal in die Ausgangsanschlüsse 10, 10′ des Ausgangswandlers.

Anders ist dies für eine akustische Signalübertragung vom Wandler 2 über die Reflektorstruktur 6 in den Ausgangswandler 4, nämlich über den akustischen Weg 7. Über die Reflektorstruktur 6 ist ein Ausgangssignal an den Anschlüssen 10, 10′ zu erhalten. Dieses über die Reflektorstruktur 6 übertragene Signal ist das im wesentlichen durch die Resonatorstruktur 6 in seiner Charakteristik bestimmte Filter-Ausgangssignal, das (im Idealfall) keinerlei Signalanteil eines direkten akustischen Übersprechens enthält.

Ein solches in-line-Filter hat Vorteile, nämlich daß für ein solches Filter eine größere Freiheit in der Wahl des Design besteht, z. B. die Wandler selbstangepaßt und der Reflektor allein den Frequenzgang entscheidend sind. Außerdem ist das erfindungsgemäße in-line Filter noch optimal platzsparend auf dem Substrat zu realisieren. Auch braucht hier das Substrat keinen besonders hohen Kopplungsfaktor aufzuweisen, wie das für Anordnungen mit Multistrip-Kopplern erforderlich ist. Für ein erfindungsgemäßes Filter sind gute Analyseprogramme verfügbar und sein Design ist sehr ähnlich dem eines Transversalfilters.

Es treten auch kaum Verluste im Reflektor auf, so daß ein erfindungsgemäßes Filter sich insoweit auch als low-loss-Filter verwenden läßt. In Fig. 1 ist, gestrichelt dargestellt, noch ein weiterer Reflektor 16 enthalten, der, bezogen auf das Wandlersystem 2, 12 und 4 und bezogen auf die Wellenausbreitungsrichtung E/A der Reflektorstruktur 6, auf dem Substrat der Struktur 6 gegenüberliegend angeordnet ist. Entsprechend dem akustischen Weg 17 läuft eine akustische Welle vom Eingangswandler 12 auch in die Reflektorstruktur 16 und zurück in den Ausgangswandler 4. Die akustische Länge des Weges vom Eingangswandler 12 über die Reflektorstruktur 16 in den Ausgangswandler 4 einerseits und die akustische Länge vom Eingangswandler 2 über die Reflektorstruktur 6 in den Ausgangswandler 4 sind zueinander so gewählt, daß die beiden in den Ausgangswandler 4 (von der Reflektorstruktur 6 und von der Reflektorstruktur 16) gelangenden akustischen Wellen sich in diesem Ausgangswandler 4 verstärken. Dazu ist in an sich bekannter Weise die passende Abstimmung der Fingeranordnungen der Wandler und der Reflektorstrukturen zu berücksichtigen, was für den Fachmann problemlos ist. Eine solche Anordnung darf nicht mit einem Resonatorfilter verwechselt werden, bei dem Resonanzen zwischen den am jeweiligen Ende des Resonatorfilters angeordneten Reflektoren erforderlich ist.

Auch darf ein erfindungsgemäßes Reflektorfilter nicht mit einer Anordnung nach der JP-A-58-223912 verwechselt werden. Eine aus dieser Offenlegungsschrift bekannte Filteranordnung hat nicht das voranstehend angegebene Abstandsverhältnis zwischen der jeweiligen Reflektorstruktur und dem ihr benachbarten Wandler, wie das für eine Ausführungsform der Erfindung gemäß Patentanspruch 2 mit einem zusätzlichen Reflektor 16 unerläßlich ist. Bei der Anordnung der genannten japanischen Offenlegungsschrift sind die zwei jeweils einem Wandler benachbart angeordneten Reflektorstrukturen dazu vorgesehen, den betreffenden Wandler zu einem unidirektional wirkenden Wandler zu machen. Dazu dürfen die beiden vorhandenen Kombinationen von Wandler und zugehörigem Reflektor die obige erfindungsgemäße Abstandsbedingung nicht erfüllen. Auch ist die Kombination der Wandler keine MBT-Anordnung, da andernfalls diese Anordnung kein Ausgangssignal liefern würde.

Ein solches Filter mit Reflektorstrukturen 6 und 16 hat extrem geringe Verluste, da praktisch sämtliche akustische Energie der Eingangswandler 2, 12 über die Reflektoren 6, 16 im Ausgangswandler 4 als Filter-Ausgangssignal wirksam wird.

Das Wandlersystem der Fig. 1 hat, wie dargestellt, einen symmetrischen Ausgangswandler und zueinander antisymmetrisch ausgeführte Eingangswandler 2, 12, die entsprechend den Anschlüssen 9, 9′ so elektrisch miteinander verbunden sind, daß diese antisymmetrische Wirkung nicht aufgehoben wird. Entsprechend könnten die Wandler 2, 12′ bezogen auf die Achse 8 auch symmetrisch ausgestaltet sein und ihre Sammelschienen werden kreuzweise elektrisch miteinander verbunden, wie dies die Fig. 2 zeigt. Die Abstände zwischen dem Wandler 4 einerseits und dem Wandler 2 bzw. dem Wandler 12 andererseits sind gleich groß oder um Vielfache von Lambda für Phasengleichheit unterschiedlich.

Anstelle dieser kreuzweisen Verbindung kann auch entsprechend Fig. 3 vorgesehen sein, den Abstand zwischen dem symmetrischen Ausgangswandler 4 und dem einen Eingangswandler 2 einerseits und den Abstand zwischen dem Ausgangswandler 4 und dem zweiten (zur Mitte 8) symmetrischen Wandler 12′ um ein ungradzahliges Vielfaches von Lambda/halbe der akustischen Welle verschieden groß zu machen.

Auch bei den Ausführungen nach den Figuren 2 und 3 führen Maßnahmen dazu, daß auf direktem akustischem Wege von dem Eingangswandlerpaar 2, 12′ kein resultierendes Signal im Ausgangswandler 4 bzw. an dessen Anschlüssen 10, 10′ auftritt.

Für das Ausführungsbeispiel der Fig. 1 ist eine Wandlerkonfiguration bestehend aus den zwei Eingangswandlern 2 und 12 vorgesehen, wohingegen der Ausgangswandler 4 ein einzelner Wandler ist. Gleiches ergibt sich, wenn man eine Ausgangswandlerkonfiguration, bestehend aus zwei Wandlern, und einen einzelnen Eingangswandler vorsieht, wenn nur die oben erläuterterten Phasenbeziehungen bezüglich des "direkten", d. h. die Resonatorstrukturen "umgehenden" akustischen Weges eingehalten sind. Das Anschlußpaar 9, 9′ und das Anschlußpaar 10, 10′ können bezüglich Eingang und Ausgang des Filters miteinander vertauscht werden.

Es können auch eine aus zwei Wandlern bestehende Eingangs- oder Ausgangswandlerkonfiguration zusammen mit einer aus drei Wandlern bestehenden Ausgangs-oder Eingangs-Wandlerkonfiguration verwendet werden, wenn ebenfalls wiederum die Phasenbeziehungen erfüllt sind. Fig. 4 zeigt das Schema einer solchen Ausführungsform einer MBT-Anordnung für die Erfindung. Die Wandler der einen Wandlerkonfiguration sind mit 2 und 12 und die Wandler der anderen Wandlerkonfiguration sind mit 4, 14 und 24 bezeichnet. Ausführungen eines erfindungsgemäßen Filters mit derartigen aus mehreren Wandlern bestehenden Wandlerkonfigurationen sind geeignet, eine größere Bandbreite zu erzielen. Fig. 4 zeigt zusätzlich weitere Reflektoren 26, 36. Die zwei Reflektoren 6, 26 und 16,26 bilden je eine an sich bekannte Resonanzskavität.

## Patentansprüche

1. Oberflächenwellen-Reflektorfilter
mit einem Substrat,
mit einem Eingangswandler (2,12) und
mit einem Ausgangswandler (4),
mit einem einzigen 180°-Reflektor (6), der zur akustischen Kopplung von Eingangswandler und Ausgangswandler miteinander angeordnet ist,
wobei eine Hauptausbreitungsrichtung (E/A) des Filters vorliegt, entlang der diese Elemente angeordnet sind,
**gekennzeichnet dadurch**
- daß von Eingangswandler (2) und Ausgangswandler (4) wenigstens einer als eine Wandlerkonfiguration (2/12; 2/12′; 2/12, 4/14/24) aufgebaut ist, wobei eine solche Wandlerkonfiguration aus mehreren Einzelwandlern (2,12,12′,4,14,24) besteht,
- daß der Eingangswandler und der Ausgangswandler um eine gemeinsame Mitte dieses Eingangs-/Ausgangs-Wandlersystems (2,4,12,14, 24) als zur Hauptausbreitungsrichtung (E/A) rechtwinkelige Achse (8) desselben angeordnet sind,
- wobei einer der Wandler (2,12) antisymmetrisch zu dieser Achse (8) wirksam ist und der dazu andere Wandler (4) zu dieser Achse (8) symmetrisch wirksam ist, so daß die vom Eingangswandler dem Ausgangswandler auf direktem Wege zugeführten Signale ausgelöscht werden und so daß das Signal über den Reflektor übertragen wird und
- daß Eingangswandler und Ausgangswandler und der Reflektor (6,16) auf der einen einzigen gemeinsamen akustischen Hauptausbreitungsrichtung (E/A) des Filters (1) liegen.

2. Oberflächenwellen-Reflektorfilter
mit einem Substrat,
mit einem Eingangswandle (2,12) und
mit einem Ausgangswandler (4),
mit mindestens zwei 180°-Reflektoren (6,16,26,36), die zur akustischen Kopplung von Eingangswandler und Ausgangswandler miteinander angeordnet sind,
wobei eine Hauptausbreitungsrichtung (E/A) des Filters vorliegt, entlang der diese Elemente angeordnet sind und
wobei, bezogen auf die Hauptausbreitungsrichtung, zu beiden Seiten der Wandler jeweils mindestens ein Reflektor (6, 16, 26, 36) angeordnet ist,
**gekennzeichnet dadurch,**
- daß von Eingangswandler (2) und Ausgangswandler (4) wenigstens einer als eine Wandlerkonfiguration (2/12; 2/12′; 2/12, 4/14/24) aufgebaut ist, wobei eine solche Wandlerkonfiguration aus mehreren Einzelwandlern (2,12, 12′,4,14,24) besteht,
- daß der Eingangswandler und der Ausgangswandler um eine gemeinsame Mitte dieses Eingangs-/Ausgangs-Wandlersystems (2, 4,12,14,24) als zur Hauptausbreitungsrichtung (E/A) rechtwinkelige Achse (8) desselben angeordnet sind,
- wobei einer der Wandler (2,12) antisymmetrisch zu dieser Achse (8) wirksam ist und der dazu andere Wandler (4) zu dieser Achse (8) symmetrisch wirksam ist, so daß die vom Eingangswandler dem Ausgangswandler auf direktem Wege zugeführten Signale ausgelöscht werden und so daß das Signal über den Reflektor übertragen wird und
- daß Eingangswandler und Ausgangswandler und alle Reflektoren (6,16,26,36) auf der einen einzigen gemeinsamen akustischen Hauptausbreitungsrichtung (E/A) des Filters (1) liegen
- und wobei der Abstand des der Achse (8) nächst benachbarten Reflektors (6) der einen Seite von dieser Achse (8) gegenüber dem Abstand des der Achse nächstbenachbarten Reflektors (16) der anderen Seite von dieser Achse (8) ein um ein ungeradzahliges Vielfaches eines Viertels der akustischen Wellenlänge Lambda im Sustrat unterschiedlich groß bemessen ist.

3. Filter nach Anspruch 1 oder 2,
**gekennzeichnet dadurch,**
daß sowohl Eingangswandler als auch Ausgangswandler je eine Wandlerkonfiguration (2,12; 4,14,24) sind.

4. Filter nach einem der Ansprüche 1 bis 3,
**gekennzeichnet dadurch,**
daß die bezogen auf die Achse (8) antisymmetrische Wirkung einer der Wandlerkonfigurationen mit geradzahliger Anzahl an Einzelwandlern (2,12) durch antisymmetrische elektrische Verbindung dieser Einzelwandler (2,12) innerhalb der Wandlerkonfiguration miteinander bewirkt ist, wobei diese Einzelwandler (2,12) dieser Wandlerkonfiguration geometrisch und konstruktiv symmetrisch zur Achse (8) sind.

5. Filter nach einem der Ansprüche 1 bis 4,
**gekennzeichnet dadurch,**
daß die Antisymmetrie der betreffenden Wandlerkonfiguration (2,12) in einer Verschiebung um ungradzahliges Vielfaches der halben akustischen Wellenlänge Lambda im Substrat gegenüber der Achse (8) besteht.

## Claims

1. Surface-wave filter
having a substrate,
having an input transducer (2,12) and
having an output transducer (4),
having a single 180° reflector (6) which is arranged for the acoustic coupling of input transducer and output transducer to one another,
in which a main propagation direction (E/A) of the filter is present, along which said elements are arranged,
characterised in that, of input transducer (2) and output transducer (4), at least one is constructed as a transducer configuration (2/12; 2/12′; 4/14/24), such a transducer configuration consisting of a plurality of individual transducers (2, 12, 12′, 4, 14, 24),
in that the input transducer and the output transducer are arranged about a common centre of said input/output transducer system (2, 4, 12, 14, 24), said centre being the axis (8) of the same, which axis is perpendicular to the main propagation direction (E/A), in that one of the transducers (2, 12) is effective antisymmetrically to said axis (8) and the other transducer (4) thereof is effective symmetrically to said axis 8, so that the signals fed by the input transducer to the output transducer on a direct path are cancelled and so that the signal is ransmitted via the reflector, and
in that input transducer and output transducer and the reflectors (6, 16) lie on the one single common acoustic main propagation direction (E/A) of the filter (1).

2. Surface-wave filter
having a substrate,
having an input transducer (2,12) and
having an output transducer (4),
having at least two 180° reflectors (6,16,26,36) which are arranged for the acoustic coupling of input transducer and output transducer to one another,
in which a main propagation direction (E/A) of the filter is present, along which said elements are arranged, and in which, in relation to the main propagation direction, in each case (at least) one reflector (6, 16, 26, 36) is arranged on either side of the transducers,
characterised in that, of input transducer (2) and output transducer (4), at least one is constructed as a transducer configuration (2/12; 2/12′; 4/14, 4/14/24), such a transducer configuration consisting of a plurality of individual transducers (2, 12, 12′, 4, 14, 24),
in that the input transducer and the output transducer are arranged about a common centre of said input/output transducer system (2, 4, 12, 14,), said centre being the axis (8) of the same, which axis is perpendicular to the main propagation direction (E/A), in that one of the transducers (2, 12) is effective antisymmetrically to said axis (8) and the other transducer (4) therefore is effective symmetrically to said axis (8),so that the signals fed by the input transucer to the outpur transducer on a direct path are cancelled and so that the signal is transmitted via the reflector, and
in that input transducer and output transducer and all reflectors (6, 16, 26, 36) lie on the one single common acoustic main propagation direction (E/A) of the filter (1), and in that the distance of the reflector (6) immediately adjacent to the axis (8) on the one side of said axis (8) in relation to the distance of the reflector (16) immediately adjacent to the axis on the other side of said axis (8) is dimensioned to be different in the substrate by an odd multiple of a quarter of the acoustic wavelength lambda.

3. Filter according to Claim 1 or 2, characterised in that both input transducer and output transducer are each a transducer configuration (2,12; 4,14,24).

4. Filter according to one of Claims 1 to 3, characterised in that the antisymmetrical effect relative to the axis (8) of one of the transducer configurations with an even number of individual transducers (2, 12) is achieved by antisymmetrical electrical connection of said individual transducers (2, 12) to one another within the transducer configuration, said individual transducers (2, 12) of said transducer configuration being symmetrical to the axis (8) both geometrically and constructionally.

5. Filter according to one of Claims 1 to 4, characterised in that the anti symmetry of the respective transducer configuration (2, 12) consists of a displacement by an odd multiple of half the acoustic wavelength lambda in the substrate relative to the axis (8).

## Revendications

1. Filtre réflecteur d'ondes de surface, comportant
un substrat,
un transducteur d'entrée (2, 12),
un transducteur de sortie (4),
un réflecteur (6) unique réalisant une réflexion à 180° et disposé de manière à réaliser le couplage acoustique entre le transducteur d'entrée et le transducteur de sortie, et
dans lequel le filtre possède une direction de propagation principale (E/A), le long de laquelle ces éléments sont disposés,
caractérisé par le fait
- qu'au moins l'un du transducteur d'entrée (2) et du transducteur de sortie (4) est agencé sous la forme d'une configuration de transducteurs (2/12; 2/12′; 2/12, 4/14/24), étant constituée par plusieurs transducteurs individuels (2,12, 12′, 4, 14, 24),
- que le transducteur d'entrée et le transducteur de sortie sont disposés autour d'un milieu commun de ce système de transducteurs d'entrée/sortie (2, 4, 12, 14, 24) servant d'axe (8) perpendiculaire à la direction de propagation principale (E/A),
- l'un des transducteurs (2, 12) agissant d'une manière antisymétrique par rapport à cet axe (8), tandis que l'autre transducteur (4) agit d'une manière symétrique par rapport à cet axe (8), de sorte que les signaux envoyés en voie directe du transducteur d'entrée au transducteur de sortie, sont supprimés et que le signal est transmis par l'intermédiaire du réflecteur, et
- que le transducteur d'entrée et le transducteur de sortie et le réflecteur (6, 16) sont situés sur la direction commune unique de propagation principale acoustique (E/A) du filtre (1).

2. Filtre réflecteur d'ondes de surface suivant la revendication 1, comportant
un substrat,
un transducteur d'entrée (2, 12),
un transducteur de sortie (4),
un réflecteur (6,16,26,36) unique réalisant une réflexion à 180° et disposé de manière à réaliser le couplage acoustique entre le transducteur d'entrée et le transducteur de sortie, et
dans lequel le filtre possède une direction de propagation principale (E/A), le long de laquelle ces éléments sont disposés, et
dans lequel respectivement au moins un réflecteur (6, 16, 26, 36) est disposé des deux côtés des transducteurs, par rapport à la direction de propagation principale, caractérisé par le fait
- qu'au moins l'un du transducteur d'entrée (2) et du transducteur de sortie (4) est agencé sous la forme d'une configuration de transducteurs (2/12; 2/12′; 2/12, 4/14/24), étant constituée de plusieurs transducteurs individuels (2, 12, 12′, 4, 14, 24),
- que le transducteur d'entrée et le transducteur de sortie sont disposés autour d'un milieu commun de ce système de transducteurs d'entrée/sortie (2, 4, 12, 14, 24) servant axe (8) perpendiculaire à la direction de propagation principale (E/A),
- l'un des transducteurs (2, 12) agissant d'une manière antisymétrique par rapport à cet axe (8), tandis que l'autre transducteur (4) agit d'une manière symétrique par rapport à cet axe (8), de sorte que les signaux envoyés en voie directe du transducteur d'entrée au transducteur de sortie, sont supprimés et que le signal est transmis par l'intermédiaire du réflecteur, et
- que le transducteur d'entrée et le transducteur de sortie et le réflecteur (6,16,26,36) sont situés sur la direction commune unique de propagation principale acoustique (E/A) du filtre (1), et
- la distance du réflecteur (6), qui est le plus voisin de l'axe (8), d'un côté de cet axe (8) étant différente de la distance du réflecteur (16), qui est le plus voisin de l'axe, de l'autre côté de cet axe (8), et ce d'un multiple impair d'un quart de la longueur d'onde acoustique lambda dans le substrat.

3. Filtre suivant la revendication 1 ou 2, caractérisé par le fait qu'aussi bien le transducteur d'entrée que le transducteur de sortie sont constitués chacun d'une configuration de transducteurs (2, 12; 4, 14, 24).

4. Filtre suivant l'une des revendications 1 à 3, caractérisé par le fait que l'action, qui est antisymétrique par rapport à l'axe (8), de l'une des configurations de transducteurs ayant un nombre pair de transducteurs individuels (2, 12) est obtenue au moyen d'une liaison électrique antisymétrique de ces transducteurs individuels (2, 12) à l'intérieur de la configuration de transducteurs, ces transducteurs individuels (2, 12) de cette configuration de transducteurs étant symétriques, du point de vue géométrique et du point de vue construction, par rapport à l'axe (8).

5. Filtre suivant l'une des revendications 1 à 4, caractérisé par le fait que l'antisymétrie de la configuration considérée de transducteurs (2, 12) consiste en un décalage, d'un multiple impair de la demi-longueur d'onde acoustique lambda dans le substrat, par rapport à l'axe (8).
